# EUROPEAN PATENT APPLICATION

(11) **EP 4 645 365 A1**
(43) Date of publication of application: **05.11.2025**
(21) Application number: 24460019.3
(22) Date of filing: 02.05.2024
(51) Int. Cl.: H01J 37/32

(54) **INTEGRATED POWER MODULE, PLASMA SUPPLY UNIT, AND PLASMA PROCESS**

(71) Applicant: TRUMPF Huettinger Sp. Z o. o., 05-220 Zielonka (PL)
(72) Inventor: The designation of the inventor has not yet been filed
(74) Representative: Trumpf Patentabteilung

(57) **Abstract**

Disclosed is an integrated power module (10) for a plasma process (66) comprising: a substrate (11) made of ceramic material with both sides metalized by direct bonded copper, a switch element (16) and a driver circuit (34), wherein the switch element (16) and the driver circuit (34) are arranged directly on the substrate (11), wherein the substrate (11) comprises a first layer (70) made from copper and a second layer (72) made from ceramic and a third layer (74) made from copper and/or aluminum, wherein the first layer (70) is directed towards the switch element (16) and the driver circuit (34), wherein the second layer (72) is arranged between the first layer (70) and the third layer (74), wherein a fluid flowable heatsink (76) made from metal sheets, in particular copper sheets, is arranged at the third layer (74), wherein the heatsink (76) and the third layer (74) are connected in a monolithic way.

## Description

The invention relates to an integrated power module for a plasma process, a plasma supply unit, and a plasma process.

WO2010091696A1 discloses a module for a plasma supply unit for supplying a plasma that is used in a plasma treatment or in a gas laser. The module comprises a substrate, on which one or more conductor tracks are provided as well as a GaN semiconductor switching element that is connected to at least one conductor track and an associated driver.

The object of the present invention is a power module for a plasma process, a plasma supply unit, and a plasma process with a better performance.

The object is solved by an integrated power module for a plasma process with the features of claim 1. The power module comprises a substrate made of ceramic material with both sides metalized by direct bonded copper; a power input and a power output; a switch element with a source contact, a drain contact and a gate contact. The switch element is preferably a power semiconductor device.

The process of direct bonded copper (DBC) is explained in more detail in the patent application: DE 102023131882.9, filed on 15.11.2023 with the title: "Kühlanordnung, Elektronikbaugruppe, elektrischer Leistungsumwandler und Verfahren zu deren Zusammenbau" which is hereby incorporated by reference in its entirety.

The switch element is set up to switch between a closing state connecting the source contact and the drain contact and an opening state disconnecting the source contact and the drain contact, and configured to withstand a voltage equal or higher than 800 V and conduct a current equal or higher than 10 A, and to be switched with a frequency equal or higher than 200 kHz.

The power input and the drain contact are connected via a drain path and the power output and the source contact are connected via a source path. The power module further comprises a switch power input, a switch power output and a signal input; a driver circuit with a driver signal contact, a driver input, a driver output and a driver gate contact. The driver input and the switch power input are connected via a driver input path. The driver output and the switch power output are connected via a driver output path. The driver signal contact and the signal input are connected via a signal path. The driver gate contact and the gate contact are connected via a gate path.

The driver circuit is set up depending on a signal at the signal input to provide a switch current at the gate contact to put the switch element in the closing state.

The switch element and the driver circuit are arranged directly on the substrate, wherein the substrate comprises a first layer made from copper and a second layer made from ceramic and a third layer made from copper and/or aluminum.

The first layer is directed towards the switch element and the driver circuit, wherein the second layer is arranged between the first layer and the third layer.

A fluid flowable heatsink made from metal sheets, in particular copper sheets, is arranged at the third layer, wherein the heatsink and the third layer are connected in a monolithic way.

In contrast to discrete devices, usage of integrated power module (IPM) enables achieving higher power density of power supply. Integration of the switch element and the driver circuit in a single packaging, in form of an integrated power module, greatly saves surface on a printed circuit board (PCB), and therefore - allows stacking integrated power modules closer together.

Therefore, the driver circuit provides a fast and efficient way of controlling the switch element. Due to the direct arrangement of the switch element and the driver circuit on the substrate made of ceramic material with both sides metalized by direct bonded copper and with multiple layers, wherein a fluid flowable heatsink is arranged at the third layer of the substrate, a sufficient cooling of the power module is ensured. Additionally, the specific arrangement of the components on the substrate ensures low parasitic inductances and thus a stable switching behavior.

Due to the arrangement of the switch element and the driver circuit onto the same substrate with the heatsink increases the driver circuits thermal stability, which is essential for high frequency switching. The thermal drift of the propagation delay for typical driver changes by 2-8 ns per 10° C. For high frequency switching process, gate signals have to be tuned with less than 1 ns accuracy, and thus a high thermal drift can be prevented. Putting the driver circuit onto the same substrate, in particular an active cooler, allows stabilizing driver's temperature, and therefore - solves the issue of changing the gate signals due to driver's thermal drift.

The substrate, in particular metalized by direct-bonded-copper (DBC), acts not only as a mechanical base for the integrated power module, but also provides electrical insulation between the switch element and the heatsink. Thus, even if two corresponding modules would touch - there should be no flashover between them due to the isolation of the substrate.

The driver circuit is any integrated circuit, which converts small signal, such as logic-level signal, e.g., into values required by a switch element, like a power semiconductor device. A small-signal is preferably higher than 0 V and smaller than 12 V, with a current capability reaching to 100 mA, while switch elements, like power semiconductors, often require both, positive and negative voltage, reaching up to +/-30 V with significantly higher current capability, e.g., equal or above 1 A. As the power density of a power supply is the nominal power (P) divided by the volume of power supply (V), getting power semiconductor devices closer to each other enables more packed design. Thus, volume of power supply (V) decreases, which - for the same nominal power (P) - increases the power density.

The heatsink may be made directly in the third layer of the substrate by additive manufacturing or connected by foils pressed in a way like direct copper bonding (DCB). The heatsink could be configured as an active cooler. As a cooling fluid water or any other coolant can be used, e.g. SF6, oil, perfluoropolyether fluorinated fluids.

In one aspect, the first layer of the substrate is separated in several first layer areas. The first layer areas may be isolated from one another.

In one aspect, the switch element is soldered connected on the first layer as a bare die. Due to a missing housing and/or a direct contact between the switch element and the first layer, the cooling effect is even more improved.

The switch element is connected with the first layer by a metal clip. Thus, an easy and fast connection with the substrate is ensured. Alternatively, the switch element, in particular the source contact and/or the gate contact, is connected with the first layer by bonding wires.

In one aspect, one or several, in particular all, of the following electrical connections are made by contact pins, configured to be connected to a main-PCB:
a) the power input,
b) the power output,
c) the switch power input,
d) the switch power output,
e) the signal input.

Thus, an easy and simple integration of the power module into the process is ensured.

In one aspect, the substrate comprises a fluid inlet and/or a fluid outlet for the heatsink. Therefore, the heatsink can be supplied with a flowable fluid to further improve the cooling of the power module and/or the components arranged on the substrate.

To increase the flexibility and enlarge the field of applications, the power module comprises an additional power output connected to the source path and/or an additional source path, and wherein, in particular, the additional source path connects the additional power output with the source contact.

In one aspect, the source path and the switch power input are connected via a first coupling path. A first capacitive arrangement may be arranged at the first coupling path between the source path and the switch power input. The first coupling path and the driver input path may be arranged in such a way that the switch current to put the switch element in the closing state is provided by the switch power input and the first capacitive arrangement. Therefore, an energy transfer to the switch element is accelerated due to additional current provided by the first capacitive arrangement. Thus, faster switching cycles are enabled. Further, the switch current does not have to be exclusively transferred from the switch power input to the switch element.

In one aspect, the source path and the switch power output are connected via a second coupling path. A second capacitive arrangement may be arranged at the second coupling path between the source path and the switch power output. The second coupling path and the switch power output may be arranged in such a way that the switch current to put the switch element in the opening state discharges to the switch power output and the second capacitive arrangement. Therefore, an energy transfer away from the switch element is accelerated due to additional current sink provided by the second capacitive arrangement. Thus, faster switching cycles are enabled. Further, the switch current does not have to be exclusively transferred from the switch element to the switch power output.

In one aspect, the first coupling path and the second coupling path are spaced apart from each other. Therefore, the current in-flow and the current out-flow with respect to the switch element take place in different areas of the substrate. As the heat can thus be dissipated over larger or different areas of the substrate, the cooling effect is further improved.

In one aspect, the driver circuit and/or the gate resistor are arranged between the first and second coupling path. This could enhance the performance further.

In one aspect, the driver circuit comprises a first semiconductor element, preferably a first transistor, and a second semiconductor element, preferably a second transistor, wherein the first semiconductor element is arranged between the driver input and the driver gate contact, and wherein the second semiconductor element is arranged between the driver output and the driver gate contact. Using semiconductor elements, in particular transistors, ensures a fast providing and/or transferring of the switch current. Thus, high-frequency switching of the switch element is enabled.

In one aspect, a resistive arrangement is arranged at the gate path between the driver gate contact and the gate contact. This could enhance the performance further.

In one aspect, the driver input path and the driver output path are connected via a third coupling path. This could enhance the performance further.

In one aspect, a third capacitive arrangement is arranged at the third coupling path between the driver input path and the driver output path. This could enhance the performance further.

In one aspect, the first capacitive arrangement and/or the second capacitive arrangement and/or the third capacitive arrangement and/or the resistive arrangement are arranged directly on the substrate. This could enhance the performance further.

In one aspect, the third layer and/or the heatsink comprises cooling channels and/or cooling fins. This could enhance the performance further.

In one aspect, the switch element is made from a SiC basis. This could enhance the performance further.

In one aspect, the switch element is made from a GaN basis. This could enhance the performance further.

In one aspect, the switch element is silver sintered to the substrate. This could enhance the performance further.

In one aspect, active or passive components can be included for additional protection or condition monitoring of the power module. This could enhance the performance further.

The object of the invention is also solved by a plasma supply unit according to claim 14.

In one aspect, the plasma supply unit comprises several integrated power modules.

In one aspect, the integrated power modules are stacked close together with a distance smaller than the quarter wavelength of the frequency, with which the switching elements are switched on and off in use. This could enhance the performance further.

The object of the invention is also solved by a plasma process, such as etching, ashing, or deposition in particular with atomic layered deposition, with at least one plasma supply unit as described in this application.

Further details and advantageous embodiments of the invention can be found in the following description, based on which embodiments of the invention are further described and explained.
Fig. 1 shows a schematic of the integrated power module circuit and a perspective view of one example.
Fig. 2 shows a side view of the integrated power module.
Fig. 3-4 each show a perspective view on two different examples of the integrated power module.
Fig. 5 shows a schematic view of a plasma supply unit.
Fig. 6 shows a a schematic view of a plasma process.

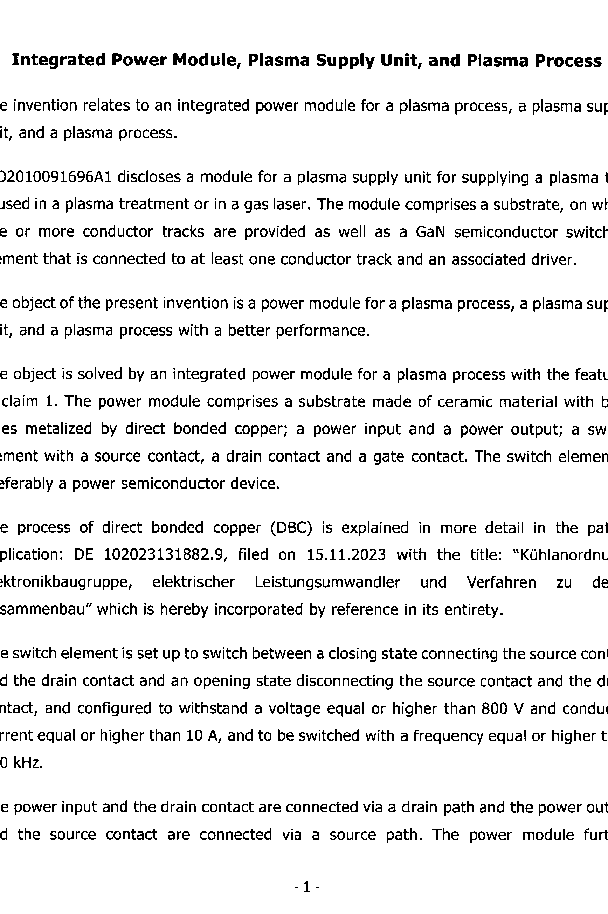

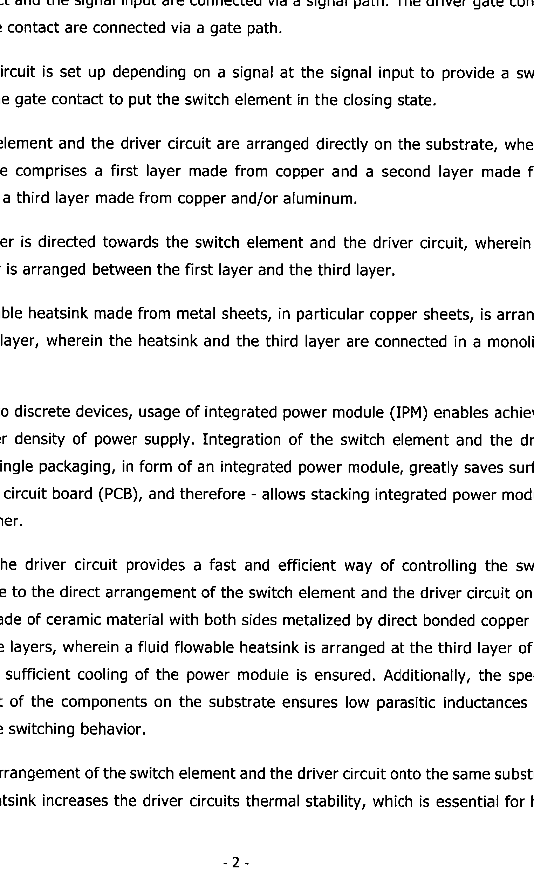

Fig. 1 shows a circuit schematic of the integrated power module 10 and a perspective view of one example of such a power module 10. That example is explained in more detail in the description of Fig. 3. In Fig. 1 the integrated power module 10 for a plasma process comprises a substrate 11 made of ceramic material with both sides metalized by direct bonded copper. According to Fig. 2, the substrate 11 comprises a first layer 70 made from copper and a second layer 72 made from ceramic and a third layer 74 made from copper and/or aluminum. The first layer 70 forms a front side of the substrate 11 and the third layer 74 forms a back side of the substrate 11. The second layer 72 is arranged between the first layer 70 and the third layer 74. The first layer 70, second layer 72 and/or the third layer 74 may consist of multiple sheets.

At the back side of the substrate a fluid flowable heatsink 76 made from metal sheets, in particular copper sheets, is arranged. The heatsink 76 is connected to the third layer 74 in a monolithic way, in particular the third layer 74 and the heatsink 76 are manufactured in a common additive manufactured process. Alternatively, the heatsink 76 is connected by foils pressed in a way like direct copper bonding (DCB) to the third layer 74. This process is also described in the patent application: DE 102023131882.9, filed on 15.11.2023. According to Fig. 3, the substrate 11 comprises a fluid inlet 77 and/or a fluid outlet 79 for the heatsink 76. So, fluid can by supplied to the heatsink 76 via the fluid inlet 77. To improve the cooling of the Power Module 10, the third layer 74 and/or the heatsink 76 comprises cooling channels 78 and/or cooling fins with respect to Fig. 2.

In Fig. 4, two heatsinks 76 are provided, wherein one heatsink 76 is arranged at the third layer 76 and another heatsink 76 is arranged at the first layer 72. It is also possible that the Power Module 10 only comprises one heatsink 76 at the first layer 72 and no heatsink at the third layer 76.

At the front side of substrate 11, the power module 10 comprises multiple components.

The power module 10 comprises a power input 12 and a power output 14. The power input 12 and/or the power output 14 are made by contact pins, preferably configured to be connected to a main-PCB. With main-PCB should be understood an electronical device comprising a PCB, electronic parts, such as resistors, inductivities, capacitors, integrated circuits, diodes transistors, copper lines and/or planes to connect those parts, and a possibility to integrate one or more of the power modules 10. The power input 12 and/or the power output 14 preferably act as power terminals.

The power module 10 further comprises a switch element 16, in particular a bare semiconductor die, preferably made from a SiC basis with a source contact 18, a drain contact 20 and a gate contact 22. The switch element 16 is set up to switch between a closing state connecting the source contact 18 and the drain contact 20 and an opening state disconnecting the source contact 18 and the drain contact 20. The switch element 16 is further configured to withstand a voltage equal or higher than 800 V and conduct a current equal or higher than 10 A. The switch element 16 is further configured to be switched with a frequency equal or higher than 200 kHz. The switch element 16 is soldered connected and/or silver sintered on the first layer 70 as a bare die or connected with the first layer 70 by a metal clip. Further, the switch element is connected with the first layer 70 by bonding wires (not shown).

In Fig. 4, the switch element 16 is arranged under the heatsink 76 at the first layer 72.

In Fig. 1, the power input 12 and the drain contact 20 are connected via a drain path 26 and the power output 14 and the source contact 18 are connected via a source path 24.

The power module 10 comprises a switch power input 28, a switch power output 30 and a signal input 32. The switch power input 28 and/or the switch power output 30 and/or the signal input 32 are made by contact pins, preferably configured to be connected to a main-PCB. The switch power input 28 and/or the switch power output 30 and/or the signal input 32 act preferably as signal terminals.

The power module 10 further comprises a driver circuit 34 with a driver signal contact 36, a driver input 38, a driver output 40 and a driver gate contact 42. The driver input 38 and the switch power input 28 are connected via a driver input path 44. The driver output 40 and the switch power output 30 are connected via a driver output path 46. The driver signal contact 36 and the signal input 32 are connected via a signal path 48. The driver gate contact 42 and the gate contact 22 are connected via a gate path 50.

The power input 12 and/or the power output 14 and/or the switch element 16 and/or the source contact 18 and/or the drain contact and/or the gate contact and/or the switch power input 28 and/or the switch power output 30 and/or the signal input 32 and/or the driver circuit 34 and/or the driver signal contact 36 and/or the driver input 38 and/or the driver output 40 and/or the driver gate contact 42 are arranged directly on the substrate 11, in particular on the front side of the substrate 11, preferably on the first layer 70.

The integration of the switch element 16, the driver circuit 34 and the coupling capacitors 54, 58, 68 on the front side of the substrate significantly reduces the length of the driver circuit 34 current loop. This allows minimizing stray inductance in the driver circuit 34, which decreases voltage overshoots, ringing on the gate signal and the turn-on/turn-off time.

In Fig. 3, the first layer 70 is divided into multiple first layer areas 70a, 70b, 70c. The power input 12 and/or the power output 14 and/or the switch element 16 and/or the source contact 18 and/or the drain contact and/or the gate contact and/or the switch power input 28 and/or the switch power output 30 and/or the signal input 32 and/or the driver circuit 34 and/or the driver signal contact 36 and/or the driver input 38 and/or the driver output 40 and/or the driver gate contact 42 may be arranged on different first layer areas 70a, 70b, 70c.

The driver circuit 34 is set up depending on a signal at the signal input 32 to provide a switch current at the gate contact 22 to put the switch element 16 in the closing state. The driver circuit 34 comprises a first semiconductor element 60, preferably a first transistor, and a second semiconductor element 62, preferably a second transistor. The first semiconductor element 60 is arranged between the driver input 38 and the driver gate contact 42. The second semiconductor element 62 is arranged between the driver output 30 and the driver gate contact 42. Using the semiconductor elements 60, 62, the switch element 16, in particular the gate contact 22, can be connected with the switch power input 28 or the switch power output 30.

By only closing the first semiconductor element 60, the switch power input 28 is connected with the gate contact 22. Then, a switch current can be supplied from the switch power input 28 to the gate contact 22. By only closing the second semiconductor element 62, the switch power output 30 is connected with the gate contact 22. Then, the switch current can flow off from the gate contact 22 to the switch power output 30.

As high-frequency switching is required for some plasma processes, the power module 10 further comprises a first capacitive arrangement 54, a second capacitive arrangement 58 and a third capacitive arrangement 68.

The source path 24 and the switch power input 38 are connected via a first coupling path 52, wherein the first capacitive arrangement 54 is arranged at the first coupling path 52. The first coupling path 52 and the driver input path 28 are arranged in such a way that the switch current to put the switch element 16 in the closing state is provided by the switch power input 28 and the first capacitive arrangement 54. If the switch is to be switched in the closing state, a current should be transferred to the switch in a short time. In a previous cycle, the first capacitive arrangement 54 has charged itself and can provide additional current for switching the switch element 16. Therefore, by closing the first semiconductor element 60, the switch power input 28 and the first capacitive arrangement 54 are connected with the gate contact 22 and supply the switch current. On the one hand, this speeds up shifting and on the other hand, fluctuations in the switch power input 28 can be compensated.

The source path 24 and the switch power output 30 are connected via a second coupling path 56, wherein the second capacitive arrangement 58 is arranged at the second coupling path 56 between the source path 24 and the switch power output 30. The second coupling path 56 and the switch power output 30 are arranged in such a way that the switch current to put the switch element 16 in the opening state discharges to the switch power output 30 and the second capacitive arrangement 58. If the switch is to be switched in the opening state, a current has to be discharged away from the switch element 16 in a short time. Besides the switch power output 30 the second capacitive arrangement 56 provides an additional sink to absorb the current. Therefore, by closing the second semiconductor element 62, the switch power output 30 and the second capacitive arrangement 58 are connected with the gate contact 22 and provide current sinks for discharging the switch current. This further speed up shifting.

The first coupling path 52 and the second coupling path 56 are arranged at a distance to each other. Due to the semiconductor elements 60, 62 the flow-in of the current to the switch element 16 takes another path than the flow-out of the current from the switch element 16. The current flow is split. Therefore, a wide area of the substrate is used to discharge the heat from the components through the layers 70, 72, 74 to the heatsink 76. Thus, the cooling is more efficient. Further, small circulating current means less interference. The equalizing currents remain on the power module 10. This prevents equalizing currents from flowing to other PCBs. The arrangement of the paths 52, 56 comes with a synergy effect of optimized cooling and stable switching (decreased voltage overshoot).

Further the components, in particular the switch element 16 and/or the driver circuit 34 and/or the first coupling path 52 and/or the second coupling path 56 are arranged on the substrate 11 in such a way, that less parasitic inductances occur. This means that there are only minor oscillations during high frequency switching of the switching element 16. Due to the reduced driver circuit loop, ringing on the switch signal can be reduced. Further, the turn-on and turn-off time is significantly decreased.

Further, a resistive arrangement 64, in particular a gate resistor, is arranged at the gate path 50 between the driver gate contact 42 and the gate contact 22. The resistive arrangement 64 of the switch element 16 effectively controls the switching speed, dampens parasitic oscillations, and optimizes efficiency by balancing switching and conduction losses, thus enhancing the overall performance and reliability of the device.

In Fig. 1, the driver input path 44 and the driver output path 46 are connected via a third coupling path 66. A third capacitive arrangement 68 is arranged at the third coupling path 66 between the driver input path 44 and the driver output path 46.

The power module 10 may comprise an additional power output 14b connected to the source path 24 and/or to an additional source path 24b. The additional source path 24b may connect the additional power output 14b also with the source contact 18.

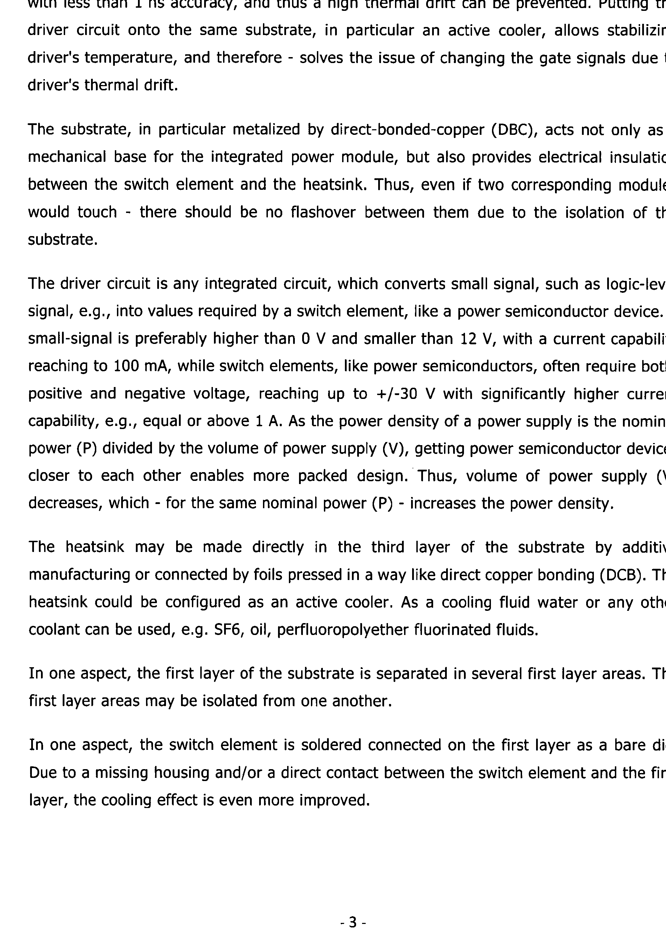

Fig. 5 shows a schematic view of a plasma supply unit 500. This plasma supply unit 500 comprises a main-PCB 541 with four integrated power modules 510, 511, 512, 513. On this main-PCB 541 are placed some electronical parts, such as a resistor 531, an inductivity 532, a capacitor 533, a diode 534 or other parts such as a transistor, copper lines and/or planes to connect those parts, and a possibility to integrate one or more of the power modules 510, 511, 512, 513. Those integrated power modules 510, 511, 512, 513 could be embodied as the integrated power module 10, as described in this application. Those power modules 510, 511, 512, 513 are stacked close together with a distance smaller than the quarter wavelength of the frequency, with which the switching elements are switched on and off in use. Those power modules 510, 511, 512, 513 could be placed even more narrow as shown in Fig. 5. Those power modules 510, 511, 512, 513 could be placed in such a way, that the fluid inlet 77 and/or fluid outlet 79 of the heatsink 76 could be stacked directly together. This is not shown in Fig. 5 but nevertheless a possible arrangement. Less space is needed then.

This plasma supply unit 500 may comprise a control section 521. With such a device the switching elements could be controlled.

This plasma supply unit 500 may comprise a DC power supply part 522. With such a device the main-PCB may be supplied with DC-power.

This plasma supply unit 500 may comprise a measuring section 523. With such a device the supply unit 500 may be controlled in a close loop manner.

Fig. 6 shows a a schematic view of a plasma process 66 with a plasma chamber 100 in which a plasma 101 is established in a plasma space. Such or similar systems are shown and described in US 2020 0118794 A1, US 10,474,184 B2, or US 10,607,813 B2 e.g..

In the plasma chamber 100 an upper electrode 103 may be positioned. A gas inlet and/or outlet, in particular a gas supply pipe 104 may be placed from the outside to the inside of the plasma chamber 100, in particular connected to the electrode 103.

A substrate 102, in particular a semiconductor wafer may be placed on a support 105 which comprises a substrate holder inside the plasma chamber 100. In use the substrate 102 may be processed by the plasma 101, e.g., in a process of etching, ashing, or deposition in particular with atomic layered deposition.

Etching process may be an extremely high challenge, for instance when the ratio between etched hole diameter and hole length is extremely low, < 1/100, e.g., as it is in deep etching often necessary. An electric conductive electrode 106 may be placed in the plasma chamber 100, in particular nearby the substrate 102, for example around the substrate 102. This electric conductive electrode 106 may be an edge ring which may be also called focus ring.

This electric conductive electrode 106 may be connected to a first power supply 114 via a first connection line 115. The first power supply 114 may be a DC pulsed power supply, where in particular the pulses may be of different length, different amplitude and shaped as described in US 9,287,086 B2 Fig. 11, 14, or US 10,474,184 B2, Fig. 2 e.g.. The first power supply 114 may be realized as a power supply unit 500 as described in this application. With the control of the first power supply 114 the electric conductive electrode 106 may be used additionally or alternatively as an ion energy and/or ion acceleration direction control as also described in US 9,287,086 B2 or US 10,474,184 B2.

A first radio-frequency (RF) power supply 118 may be electrically connected to the support 105 via a first power feeding rod 119 and a first matching unit 116 and a first connection unit 117. The first radio-frequency (RF) power supply 118 may be realized as a power supply unit 500 as described in this application.

A second radio-frequency (RF) power supply 108 may be electrically connected to the upper electrode 103 via a second power feeding rod 109 and a second matching unit 110 and a second connection unit 111. The second radio-frequency (RF) power supply 108 may be realized as a power supply unit 500 as described in this application.

An electrode 107 may be positioned in or nearby the support 105 and is electrically connected to a second power supply 112 via a second connection line 113. The second power supply 112 may be a DC pulsed power supply, where in particular the pulses may be of different length, different amplitude and shaped as described in US 9,287,086 B2 Fig. 11, 14, or US 10,474,184 B2, Fig. 2, e.g.. The second power supply 112 may be realized as a power supply unit 500 as described in this application.

The substrate 102 may be fixed at the support 105 via the electrode 107 which may work as an electrostatic chuck. With the control of the second power supply 112 the electrode 107 may be used additionally or alternatively as an ion energy and/or ion acceleration direction control as described in US 9,287,086 B2 or US 10,474,184 B2.

Some plasma treatment processes, such as etching or layer deposition, demand a high voltage (HV), high frequency (HF), rectangular, asymmetrical, pulsed voltage supply. Often the voltage values significantly exceed the voltage handling possibilities of individual semiconductor switches, especially when high frequency operation is required.

Some plasma processes require not only pulsing, but pulse-to-pulse amplitude variation. Some plasma processes require the source to deliver high peak currents in order to obtain short voltage transition times. Most plasma processes present a load, which contains a capacitive component. Significant power loss is related to the pulse-by-pulse charging and discharging process of this load capacitance. Some plasma processes require pulse shaping as described in US 9,287,086 B2 Fig. 11, 14, or US 10,474,184 B2, Fig. 2, e.g..

## Claims

1. Integrated power module (10) for a plasma supply unit (500) and/or a plasma process (66), comprising:
- a substrate (11) made of ceramic material with both sides metalized by direct bonded copper;
- a power input (12) and a power output (14);
- a switch element (16) with a source contact (18), a drain contact (20) and a gate contact (22);
wherein the switch element (16) is set up to switch between a closing state connecting the source contact (18) and the drain contact (20) and an opening state disconnecting the source contact (18) and the drain contact (20), and configured to withstand a voltage equal or higher than 800 V and conduct a current equal or higher than 10 A, and to be switched with a frequency equal or higher than 200 kHz,
wherein the power input (12) and the drain contact (20) are connected via a drain path (26) and the power output (14) and the source contact (18) are connected via a source path (24);
- a switch power input (28), a switch power output (30) and a signal input (32);
- a driver circuit (34) with a driver signal contact (36), a driver input (38), a driver output (40) and a driver gate contact (42), wherein the driver input (38) and the switch power input (28) are connected via a driver input path (44), the driver output (40) and the switch power output (30) are connected via a driver output path (46), and the driver signal contact (36) and the signal input (32) are connected via a signal path (48), and wherein the driver gate contact (42) and the gate contact (22) are connected via a gate path (50);
wherein the driver circuit (34) is set up depending on a signal at the signal input (32) to provide a switch current at the gate contact (22) to put the switch element (16) in the closing state;
wherein the switch element (16) and the driver circuit (34) are arranged directly on the substrate (11),
wherein the substrate (11) comprises a first layer (70) made from copper and a second layer (72) made from ceramic and a third layer (74) made from copper and/or aluminum,
wherein the first layer (70) is directed towards the switch element (16) and the driver circuit (34), wherein the second layer (72) is arranged between the first layer (70) and the third layer (74),
wherein a fluid flowable heatsink (76) made from metal sheets, in particular copper sheets, is arranged at the third layer (74),
wherein the heatsink (76) and the third layer (74) are connected in a monolithic way.

2. Integrated power module (10) according to claim 1, wherein the first layer (70) is separated in several first layer areas (70a, 70b, 70c).

3. Integrated power module (10) according to claim 1 or 2, wherein the switch element (16) is soldered connected on the first layer (70) as a bare die.

4. Integrated power module (10) according to any of proceeding claims, wherein one or several, in particular all, of the following electrical connections are made by contact pins, configured to be connected to a main-PCB:
a) the power input (12),
b) the power output (14),
c) the switch power input (28),
d) the switch power output (30),
e) the signal input (32).

5. Integrated power module (10) according to any of proceeding claims, further comprising an additional power output (14b) connected to the source path (24) and/or to an additional source path (24b), and wherein, in particular, the additional source path (24b) connects the additional power output (14b) with the source contact (18).

6. Integrated power module (10) according to any of proceeding claims, wherein the source path (24) and the switch power input (38) are connected via a first coupling path (52), and wherein a first capacitive arrangement (54) is arranged at the first coupling path (52) between the source path (24) and the switch power input (38).

7. Integrated power module (10) according to claim 6, wherein the first coupling path (52) and the driver input path (28) are arranged in such a way that the switch current to put the switch element (16) in the closing state is provided by the switch power input (28) and the first capacitive arrangement (54).

8. Integrated power module (10) according to any of proceeding claims, wherein the source path (24) and the switch power output (30) are connected via a second coupling path (56), and wherein a second capacitive arrangement (58) is arranged at the second coupling path (56) between the source path (24) and the switch power output (30).

9. Integrated power module (10) according to claim 8, wherein the second coupling path (56) and the switch power output (30) are arranged in such a way that the switch current to put the switch element (16) in the opening state discharges to the switch power output (30) and the second capacitive arrangement (58).

10. Integrated power module (10) according to any of the claims 6 to 9, wherein the first coupling path (52) and the second coupling path (56) are spaced apart from each other.

11. Integrated power module (10) according to any of the proceeding claims, wherein the driver circuit (34) comprises a first semiconductor element (60), preferably a first transistor, and a second semiconductor element (62), preferably a second transistor, wherein the first semiconductor element (60) is arranged between the driver input (38) and the driver gate contact (42), and wherein the second semiconductor element (62) is arranged between the driver output (30) and the driver gate contact (42).

12. Integrated power module (10) according to any of the proceeding claims, wherein the third layer (74) and/or the heatsink (76) comprises cooling channels (78) and/or cooling fins.

13. Integrated power module (10) according to any of the proceeding claims, wherein the switch element (16) is silver sintered to the substrate (11).

14. Plasma supply unit (500) with an integrated power module (10) according to any of the proceeding claims.

15. Plasma process (66) with a plasma supply unit (500) according to claim 14.
